# EUROPÄISCHE PATENTSCHRIFT

(11) **EP 1 053 662 B1**
(45) Veröffentlichungstag und Bekanntmachung des Hinweises auf die Patenterteilung: **26.09.2001**
(21) Anmeldenummer: 98966631.8
(22) Anmeldetag: 16.12.1998
(51) Int. Cl.: H05K 7/20, H02B 1/56

(54) **LÜFTER ZUM ANBAU AN EIN WANDELEMENT EINES SCHALTSCHRANKES**
FAN FOR MOUNTING ON A WALL MEMBER OF A CONTROL CABINET
VENTILATEUR DESTINE A ETRE MONTE SUR UN ELEMENT DE PAROI D'UNE ARMOIRE DE COMMANDE

(30) Priorität: 07.02.1998 DE 19804906
(43) Veröffentlichungstag der Anmeldung: 22.11.2000
(73) Patentinhaber: Rittal-Werk Rudolf Loh GmbH & Co. KG, 35745 Herborn (DE)
(72) Erfinder: PAWLOWSKI, Adam, D-35713 Eschenburg-Wissenbach (DE)
(74) Vertreter: Fleck, Hermann-Josef, Dr.-Ing.
(86) Internationale Anmeldenummer: EP9808257
(87) Internationale Veröffentlichungsnummer: WO9940766

(56) Entgegenhaltungen:
- DE-U- 9 303 275
- FR-A- 2 193 303
- PATENT ABSTRACTS OF JAPAN vol. 018, no. 480 (E-1603), 8. September 1994 & JP 06 164175 A (RICOH CO LTD), 10. Juni 1994
- PATENT ABSTRACTS OF JAPAN vol. 013, no. 230 (E-764), 26. Mai 1989 & JP 01 036100 A (FUJITSU LTD), 7. Februar 1989

## Beschreibung

Die Erfindung betrifft einen Lüfter mit Eingangs- und Ausgangs-Befestigungsebene zum Anbau an ein mit Lüftungsdurchbruch versehenes Wandelement eines Schaltschrankes, wobei eine Lüftereinheit eingangs- und ausgangsseitig identische und parallel zueinander ausgerichtete Befestigungsflansche aufweist, wobei eine Lüftereinheit eingangs- und ausgangsseitig identische und parallel zueinander ausgerichtete Befestigungsflansche aufweist und aus der Lüftereinheit und einem Zusatzgehäuse zusammengesetzt ist.

Derartige Lüftereinheiten sind in den verschiedensten Ausführungen bekannt, wobei sie mit dem einen oder anderen Befestigungsflansch direkt mit dem Wandelement verbindbar sind. Derartige Lüftereinheiten sind handelsüblich, in verschiedenen Größen lieferbar und für verschiedene Einsatzbedingungen zu beziehen. Dabei ist in der Regel der Luftstrom im Bereich der Eingangs- und Ausgangs-Befestigungsebene gleich ausgerichtet und senkrecht zu diesen Ebenen, wie die WO 96/41 511 erkennen lässt.

Wie aus Patent Abstracts of Japan, Band 18, Nr. 480 (E-1603), 8.9.94 und JP 06 164175A (Ricoh Co. Ltd.) bekannt ist, kann eine derartige Lüftereinheit nur parallel zueinander verlaufenden Befestigungsebenen auch mit einem Zwischengehäuse als Lüfter der eingangs erwähnten Art an dem Wandelement angebracht werden, wobei dessen Ausgangsebene jedoch nach wie vor parallel zum Wandelement verläuft und keine Veränderung der Strömungsrichtung der Lüftereinheit bewirkt. Die Strömungsrichtung bleibt nach wie vor senkrecht zu den Befestigungsebenen und zum Lüftungsdurchbruch des Wandelementes.

Wie die US 4,648,007 zeigt, können derartige Lüftereinheiten in einem zu belüftenden Gehäuse an unterschiedlich geneigten Bereichen eines Wandelementes befestigt werden, um die Richtung des Luftstromes zu verändern. Dies ist aus Platzgründen bei einem ebenen Wandelement eines Schaltschrankes nicht sinnvoll, da die Lüftereinheit je nach Bestückung des Schaltschrankes an verschiedenen Stellen des Wandelementes anzubringen sind.

Es ist auch bekannt, bei Kühleinrichtungen speziell ausgebildete Ventilatoren zu verwenden. Dabei steht die Eingangs-und die Ausgangs-Befestigungsebene der Lüftereinheit im spitzen Winkel zueinander, wobei die Wirkung des Lüfters als Saug- oder Druck-Lüfter vorgegeben ist, wie die WO 88/01127 zeigt. Außerdem können die Lüfter je nach Einsatzort auch als Filterlüfter ausgebildet werden, wie die US 5,528,454 zeigt.

Bei dem Einsatz derartiger Lüfter im Schaltschrankinneren sind besondere Anforderungen zu stellen. Die Luft wird an verschiedenen Stellen aus dem Schrankinneren abzusaugen sein und muss auch an unterschiedlichen Stellen wieder dem Schrankinneren zuführbar sein. Dies setzt einen flexiblen Einbau voraus, der den Gegebenheiten anzupassen ist. Das Wandelement ist dabei häufig doppelwandig ausgebildet und als Luftkanal verwendet und dient oft sogar als Wärmetauscher-Gehäuse. Das Wandelement aus einem äußeren und inneren Wandblatt bildet einen sehr flachen Luftkanal, der zu Luftstauungen führt, da der angesaugte und dem Luftkanal zugeführte Luftstrom auf das äußere Wandelement prallt, was zur Wirbelbildung führt. Außerdem ist der Luftstrom in seiner Ansaugrichtung nicht optimal an die Gegebenheiten anzupassen, wenn handelsübliche Lüftereinheiten eingesetzt werden sollen.

Aus FR-A-2 193 303 ist ein Schaltschrank bekannt, der mit einer aus aüßeren und inneren Wandelement gebildeten, als Wärmetauscher dienenden doppelwandigen Wand versehen ist, wobei das innere Wandelement im oberen und unteren Bereich mit Durchbrüchen zum Anschluß eines Lüfters versehen ist.

Es ist Aufgabe der Erfindung, einen Lüfter der eingangs erwähnten Art so auszugestalten, dass er nicht nur,wahlweise als Saug- oder Druck-Lüfter am Wandelement angebaut werden kann, sondern dass auch der angesaugte oder ausgeblasene Luftstrom in seiner Strömungsrichtung im Bezug auf das Wand-element mit dem Lüftungsdurchbruch an die Gegebenheiten angepasst werden kann.

Diese Aufgabe wird nach der Erfindung dadurch gelöst, der Lüfter aus einer Lüftereinheit und einem Zwischengehäuse zusammensetzbar ist, wobei die Lüftereinheit als Saug- oder Druck-Lüfter betreibbar und mit dem Zwischengehäuse verbindbar ist,
dass die Lüftereinheit eingangs-und ausgangsseitig identische und parallel zueinander ausgerichtete Befestigungsflansche trägt, die wahlweise mit einer Eingangs-Befestigungsebene des Zwischengehäuses verbindbar sind,
dass die mit dem inneren Wandelement verbindbare Ausgangs-Befestigungsebene des Zwischengehäuses im spitzen Winkel zur Eingangs-Befestigungsebene desselben steht,
dass eine als Saug-Lüfter mit dem Zwischengehäuse verbundene Lüftereinheit über das Zwischengehäuse im Bereich eines oberen Durchbruchs mit dem inneren Wandelement verbunden ist, und
dass der in dem Wärmetauscher aus dem Schaltschrank abgesaugte Luftstrom eine nach unten gerichtete Komponente aufweist, während eine als Druck-Lüfter mit dem Zwischengehäuse verbundene Lüftereinheit den Luftstrom mit einer von oben nach unten gerichteten Komponente aus dem Wärmetauscher absaugt und in den Schaltschrank zurückführt.

Bei dieser Ausgestaltung des Lüfters kann die Lüftereinheit mit dem einen oder anderen Befestigungsflansch mit der Eingangs-Befestigungsebene des Zwischengehäuses verbunden werden, so dass der Luftstrom zwischen dem Luftkanal des Wandelementes und der Lüftereinheit nicht mehr senkrecht zum äußeren Wandblatt gerichtet ist, sondern eine den Durchgang förderliche Bewegungskomponente aufweist, die je nach Gegebenheit durch unterschiedlichen Anbau des Zwischengehäuses am Wandelement beeinflusst und geändert werden kann.

Der wahlweise Einsatz des Lüfters wird dadurch noch vereinfacht, dass die Befestigungsflansche des Lüftergehäuses rechteckig oder quadratisch ausgebildet ist, und dass die Befestigungsaufnahmen der Befestigungsflansche des Lüftergehäuses und der Eingangs-Befestigungsebene des Zwischengehäuses aufeinander abgestimmt sind.

Für die Verbindung des Zwischengehäuses mit dem Wandelement ist vorgesehen, dass die Ausgangs-Befestigungsebene des Zwischengehäuses mit Befestigungsbohrungen für Befestigungsschrauben versehen ist, die in Schraubaufnahmen im Bereich der Durchbrüche des Wandelementes einschraubbar sind.

Das Zwischengehäuse ist zwischen der Eingangs-Befestigungsebene mit Eintrittsöffnung und der Ausgangs-Befestigungsebene mit Austrittsöffnung mittels Wandteilen geschlossen. Der Lüfter ist vorzugsweise als Filterlüfter ausgebildet.

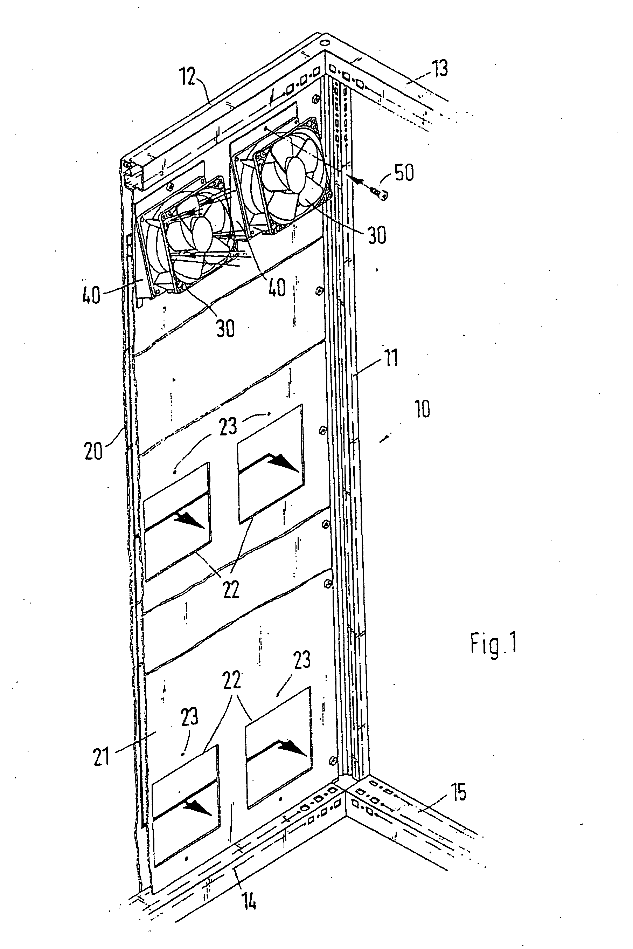

Die Teilansicht nach Fig. 1 zeigt von einem Rahmengestell 10 eines Schaltschrankes einen vertikalen Rahmenschenkel 11, an dem oben die horizontalen Rahmenschenkel 12 und 13 sowie an dem unten die horizontalen Rahmenschenkel 14 und 15 angebracht sind. Eine Seite des Rahmengestelles 10 ist mit einer doppelwandigen Wand aus einem inneren Wandelement 21 und einem äußeren Wandelement 20 verschlossen. Das innere Wandelement 21 hat quadratische Durchbrüche 22, die über den Zwischenraum zwischen den beiden Wandelementen 20 und 21 miteinander verbunden sind. Im Ausführungsbeispiel sind die Durchbrüche 22 paarweise im oberen, mittleren und unteren Bereich des inneren Wandelementes 21 eingebracht. Der Zwischenraum zwischen den beiden Wandelementen 20 und 21 kann auch in Luftkanäle unterteilt sein, die die Durchbrüche vertikal miteinander verbinden. In dieser Ausgestaltung dient die doppelwandige Wand als Wärmetauscher, wenn die angesaugte Wärme Luft aus dem Schaltschrank mit dem durch die Außenluft gekühlten äußeren Wand-element 20 in Kontakt kommt, so daß sie gekühlt über die nicht mit Lüftern abgeschlossenen Durchbrüche 22 wieder in den Schaltschrankinnenraum gelangen kann. Das innere Wandelement 21 kann auch aus mehreren Teil-Wandelementen zusammengesetzt sein.

Die Lüfter sind nun so ausgebildet, daß die Eingangs-Befestigungsebene und die Ausgangs-Befestigungsebene im spitzen Winkel zueinander stehen. Daher saugen die gemäß Fig. 1 befestigten Lüfter die Luft schräg von oben, d.h. von der wärmsten Stelle unter dem Deckblech des Schaltschrankes ab. Der angesaugte Luftstrom hat ein Gefälle nach unten und trifft mit einer nach unten gerichteten Komponente auf das äußere Wandelement 20. Der Aufprall auf dem äußeren Wandelement 20 führt daher zu keiner merklichen Wirbelbildung und zu keinem Stau, so daß ein wesentlich strömungsgünstiger Verlauf des angesaugten Luftstromes über den Wärmetauscher erreicht wird. Dies bringt einen wesentlich besseren Wirkungsgrad des Wärmetauschers.

Um die Neigung im spitzen Winkel zwischen der Eingangs- und Ausgangs-Befestigungsebene des Lüfters zu erreichen, gibt es mehrere Möglichkeiten. Das Lüftergehäuse kann zweigeteilt sein, wobei die Gehäuseteile im zusammengesetzten Zustand mit ihren abschließenden Befestigungsflansche im spitzen Winkel zueinander stehen. Dabei kann die Lüftereinheit in beiden Richtungen in das zusammengesetzte Lüftergehäuse eingesetzt werden, so daß der Lüfter als Saug- oder Druck-Lüfter ausgebildet sein kann.

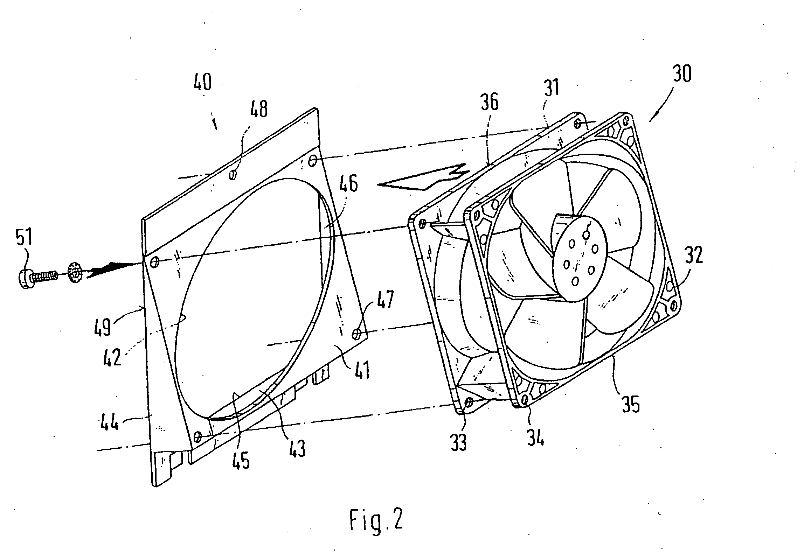

Eine vorteilhafte Ausgestaltung des Lüfters zeigt Fig. 2 unter Verwendung einer handelsüblichen quaderförmigen Lüftereinheit 30. Diese Lüftereinheit 30 schließt mit Befestigungsflanschen 31 und 32 ab, die Befestigungsebenen 35 und 36 definieren, welche parallel zueinander verlaufen. Die beiden Befesti-gungsflansche 31 und 32 sind identisch und vorzugsweise quadratisch ausgebildet und tragen in gleicher Anordnung Befestigungsaufnahmen 33 und 34. Damit ein Anbau des Lüfters an die Wand in Schrägstellung erfolgen kann, wird die Lüftereinheit 30 mit einem Zwischengehäuse 40 verbunden, wobei wieder die Möglichkeit besteht, den Befestigungsflansch 31 oder den Befestigungsflansch 32 mit der Eingangs-Befestigungsebene 41 des Zwischengehäuses 40 zu verbinden. Im Bereich der Eingangs-Befestigungsebene 41 sind daher die Befestigungsaufnahmen 33 bzw. 34 der Lüftereinheit 30 abgestimmte Befestigungsaufnahmen 47 eingebracht. Die Eingangs-Befestigungsebene 41 des Zwischengehäuses 40 hat eine zentrische Eintrittsöffnung 42. Auf der Ausgangsseite des Zwischengehäuses 40 bilden Wände 43, 44 und 46 mit Rahmenteilen eine Ausgangs-Befestigungsebene 49, die im spitzen Winkel zu der Eingangs-Befestigungsebene 41 steht. Die Wände 43, 44 und 46 lassen mit den Rahmen-teilen in der Ausgangs-Befestigungsebene 49 eine Austrittsöffnung 45 frei. Mit Schrauben 51 wird die Lüftereinheit 30 am Zwischengehäuse 40 befestigt.

Der aus Lüftereinheit 30 und Zwischengehäuse 40 zusammengebaute Lüfter wird mit Befestigungsschrauben 50 an dem inneren Wandelement 21 befestigt. Die Befestigungsschrauben 50 werden durch Befestigungsbohrungen 48 des Rahmenteils des Zwischengehäuses 40 geführt und in Schraubaufnahmen 23 des inneren Wandelementes 21 eingeschraubt, welche im Bereich der Durchbrüche 22 angeordnet sind.

Der Lüfter wird in der Anbringung nach Fig. 1 als Saug-Lüfter verwendet. Ist er als Druck-Lüfter ausgebildet, dann kann er um 180° gedreht und anderer, nach unten gerichteter Neigung im Bereich der unteren Durchbrüche 22 angebracht werden. Dabei wird die Luft über den Wärmetauscher angesaugt und an der tiefsten Stelle gekühlt in den Schaltschrankinnenraum eingeleitet.

## Patentansprüche

1. Schaltschrank mit einer aus äußerem und innerem Wandelement (20 und 21) gebildeten, als Wärmetauscher dienenden doppelwandigen Wand, wobei das innere Wandelmeent (21) im oberen und unteren Bereich mit Durchbrüchen zum Anschluss eines Lüfters versehen ist,
**dadurch gekennzeichnet,**
**dass** der Lüfter aus eier Lüftereinheit (30) und einem Zwischengehäuse (40) zusammensetzbar ist, wobei dle Lüftereinheit (30) als Saug- oder Druck-Lüfter betreibbar und mlt dem Zwischengehäuse (40) verbindbar ist,
dass eine Lüftereinheit (30) eingangs- und ausgangsseitig identische und parallel zueinander ausgerichtete Befestigungsflansche (31, 331 trägt, die wahlweise mit einer Eingangs-Befestigungsebene (41 des Zwischengehäuses (40) verbindbar sind,
dass die mit dem inneren Wandelement (21) verbindbare Ausgangs-Befestigungsebene (49) des Zwischengehäuses (40) im spitzen Winkel zur Eingangs-Befestigungsebene (41) desselben steht,
dass eine als Saug-Lüfter mit dem Zwischengehäuse (40) verbundene Lüftereinheit (30) über das Zwischengehäuse (40) im Bereich eines oberen Durchbruches (22) mit dem inneren Wandelement (21) verbunden ist, und
dass der in dem Wärmetauscher aus dem Schaltschrank abgesaugte Luftstrom eine nach unten gerichtete Komponente aufweist, während eine als Druck-Lüfter mit dem Zwischengehäuse (40) verbundene Lüftereinhelt (30) den Luftstrom mit einer von oben nach unten gerichteten Komponente aus dem Wärmetauscher absaugt und in den Schaltschrank zurückführt,

2. Schaltschrank nach Anspruch 1,
**dadurch gekennzeichnet,**
**dass** die Befestigungsflansche (31, 32) der Lüftereinheit (30) rechteckig oder quadratisch ausgebildet sind.

3. Schaltschrank nach Anspruch 1 oder 2,
**dadurch gekennzeichnet,**
**dass** die Ausgangs-Befestigungsebene (49) des Zwischengehäuses (40) mit Befestigungsbohrungen (48) für Befestigungsschrauben (50) versehen ist, die in Schraubaufnahmen (23) im Bereich der Durchbrüche (22) des Wandelementes (21) einschraubbar sind.

4. Schaltschrank nach einem der Ansprüche 1 bis 3,
**dadurch gekennzeichnet,**
**dass** das Zwischengehäuse (40) zwischen der Eingangs-Befestigungsebe-ne (41) mit Eintrittsöffnung (42) und der Ausgangs-Befestigungsebene (49) mit Austrittsöffnung (45) mittels Wandteilen (43, 44, 46) geschlossen ist.

5. Schaltschrank nach einem der Ansprüche 1 bis 4,
**dadurch gekennzeichnet,**
**dass** der Lüfter als Filterlüfter ausgebildet ist.

6. Schaltschrank nach einem der Ansprüche 1 bis 5,
**dadurch gekennzeichnet,**
**dass** der Lüfter als Saug- oder Druck-Lüfter betreibbar ist.

## Claims

1. Switch cabinet with a double-walled wall which is formed from an outer wall element and an inner wall element (20 and 21) and serves as a heat exchanger, the inner wall element (21) being provided, in the top and bottom regions, with through-passages for the connection of a fan, **characterized in that** the fan may be assembled from a fan unit (30) and an intermediate housing (40), it being possible for the fan unit (30) to be operated as a suction or pressure fan and to be connected to the intermediate housing (40), in that a fan unit (30) bears fastening flanges (31, 33) which are identical on the input and output sides, are aligned parallel to one another and can be connected optionally to an input fastening plane (41) of the intermediate housing (40), in that the output fastening plane (49) of the intermediate housing (40), it being possible for said output fastening plane to be connected to the inner wall element (21), is at an acute angle to the input fastening plane (41) of the intermediate housing, in that a fan unit (30) connected as a suction fan to the intermediate housing (40) is connected to the inner wall element (21), via the intermediate housing (40), in the region of a top through-passage (22), and in that the air stream extracted by suction from the switch cabinet in the heat exchanger has a downwardly directed component, while a fan unit (30) connected as a pressure fan to the intermediate housing (40) extracts the air stream from the heat exchanger by suction with a component directed from top to bottom and leads it back into the switch cabinet.

2. Switch cabinet according to Claim 1, **characterized in that** the fastening flanges (31, 32) of the fan unit (30) are of rectangular or square design.

3. Switch cabinet according to Claim 1 or 2, **characterized in that** the output fastening plane (49) of the intermediate housing (40) is provided with fastening bores (48) for fastening screws (50) which can be screwed into screw-connection mounts (23) in the region of the through-passages (22) of the wall element (21).

4. Switch cabinet according to one of Claims 1 to 3, **characterized in that** wall parts (43, 44, 46) close the intermediate housing (40) between the inlet fastening plane (41) with inlet opening (42) and the outlet fastening plane (49) with outlet opening (45).

5. Switch cabinet according to one of Claims 1 to 4, **characterized in that** the fan is designed as a filter fan.

6. Switch cabinet according to one of Claims 1 to 5, **characterized in that** the fan can be operated as a suction or pressure fan.

## Revendications

1. Armoire de commutation avec une paroi double formée par un élément extérieur et un élément intérieur de paroi (20 et 21), servant d'échangeur de chaleur, l'élément intérieur de paroi (21) étant doté dans sa partie supérieure et dans sa partie inférieure de percements pour le raccordement d'un ventilateur,
**caractérisée en ce que**
le ventilateur est constitué de l'assemblage d'une unité de ventilateur (30) et d'un caisson intermédiaire (40), l'unité de ventilation (30) pouvant être utilisée comme ventilateur d'aspiration ou comme ventilateur de refoulement et pouvant être reliée au caisson intermédiaire (40),
en ce qu'une unité de ventilateur (30) porte des brides de fixation (31, 33) orientées parallèlement l'une à l'autre et identiques du côté de l'entrée et du côté de la sortie, qui peuvent être reliés sélectivement à un plan de fixation d'entrée (41) du caisson intermédiaire (40),
en ce que le plan de fixation de sortie (49) du caisson intermédiaire (40) apte à être relié à l'élément intérieur de paroi (21) forme un angle aigu avec le plan de fixation d'entrée (41),
en ce qu'une unité de ventilateur (30) servant de ventilateur d'aspiration et reliée au caisson intermédiaire (40) est reliée à l'élément intérieur de paroi (21) par l'intermédiaire du caisson intermédiaire (40) dans région d'un percement supérieur (22),
et en ce que l'écoulement d'air aspiré dans l'échangeur de chaleur en provenance de l'armoire de commutation présente une composante orientée vers le bas, tandis qu'une unité de ventilateur (30) servant de ventilateur de refoulement et
reliée au caisson intermédiaire (40) aspire l'écoulement d'air hors de l'échangeur de chaleur avec une composante orientée du haut vers le bas et le renvoie dans l'armoire de commutation.

2. Armoire de commutation selon la revendication 1,
**caractérisée en ce que** les brides de fixation (31, 32) de l'unité de ventilateur (30) présentent une configuration rectangulaire ou carrée.

3. Armoire de commutation selon la revendication 1 ou 2, **caractérisée en ce que** le plan de fixation de sortie (49) du caisson intermédiaire (40) est doté d'alésages de fixation (48) pour des vis de fixation (50) qui peuvent être vissées dans des logements de vis (23) dans la région des percements (22) de l'élément de paroi (21).

4. Armoire de commutation selon l'une des revendications 1 à 3, **caractérisée en ce que** le caisson intermédiaire (40) est fermé au moyen de parties de paroi (43, 44, 46) entre le plan de fixation d'entrée (41) doté d'une ouverture d'entrée (42) et le plan de fixation de sortie (49) doté d'une ouverture de sortie (45).

5. Armoire de commutation selon l'une des revendications 1 à 4, **caractérisée en ce que** le ventilateur est configuré comme ventilateur - filtre.

6. Armoire de commutation selon l'une des revendications 1 à 5, **caractérisée en ce que** le ventilateur peut être utilisé comme ventilateur d'aspiration ou comme ventilateur de refoulement.
